# EUROPÄISCHE PATENTANMELDUNG

(11) **EP 1 612 500 A2**
(43) Veröffentlichungstag der Anmeldung: **04.01.2006**
(21) Anmeldenummer: 05013930.2
(22) Anmeldetag: 28.06.2005
(51) Int. Cl.: F28D 15/02

(54) **Instrumenten-Schutzgehäuse, insbesondere Instrumentenschutzhaus für elektrische Instrumente und Analysegeräte**

(30) Priorität: 30.06.2004 DE 102004031474
(71) Anmelder: Hess, Martin, 85051 Ingolstadt (DE)
(72) Erfinder: Hess, Martin, 85051 Ingolstadt (DE)
(74) Vertreter: Liebl, Thomas

(57) **Zusammenfassung**

Die Erfindung betrifft ein Instrumenten-Schutzgehäuse, insbesondere Instrumentenschutzhaus für elektrische Instrumente und Analysegeräte, mit einer Gehäusewand, wobei wenigstens ein Teilbereich der Gehäusewand als Wärmetauscher-Wandbereich (3; 21; 41; 54) ausgebildet ist, und wobei in den Wärmetauscher-Wandbereich (3; 21; 41; 54) wenigstens ein interner Wärmetauscher (4; 23; 43; 57) integriert ist, mittels dem ein Wärmetausch mit dem Innenraum (7; 27; 55) des Schutzgehäuses (1; 20; 53) durchführbar ist. Erfindungsgemäß ist der interne Wärmetauscher (4; 23; 43) mit wenigstens einem externen Wärmetauscher (9; 22; 44), mittels dem ein Wärmetausch mit der Außenumgebung (28) des Schutzgehäuses (1; 20) durchführbar ist, strömungsverbunden, wobei die miteinander strömungsverbundenen internen und externen Wärmetauscher (4, 9; 22, 23; 43, 44) jeweils ein vorgegebenes Aufnahmevolumen für eine vorgegebene Menge einer zwischen diesen in einem geschlossenen System zirkulierbaren Wärmetausch-Flüssigkeit, insbesondere Wasser, aufweisen.

## Beschreibung

Die Erfindung betrifft ein Instrumenten-Schutzgehäuse, insbesondere ein Instrumentenschutzhaus für elektrische Instrumente und Analysegeräte, nach dem Oberbegriff des Anspruchs 1.

Instrumenten-Schutzgehäuse sind in verschiedenen Ausführungsformen bekannt, so z. B. als Instrumenten-Schutzkästen, die relativ kleinvolumig ausgebildet sind und an einer Wand befestigt werden und in denen kleinere elektrische Instrumente angeordnet sind. Weiter sind insbesondere in Verbindung mit einem industriellen Einsatz großvolumige und großbauende Schutzgehäuse als Instrumentenschutzhäuser bekannt, in denen entsprechend großbauende elektrische Instrumente und Analysegeräte aufgenommen und verwahrt werden können. Derartige Instrumentenhäuser als Schutzgehäuse finden z. B. als Analysenhäuser für Umweltmessstationen, für Mobilfunkstationen im Telekommunikationsbereich, für Schaltanlagen als Gleichrichtergehäuse sowie für Gasregelstationen Verwendung. Derartige großvolumige Schutzgehäuse bzw. Instrumentenschutzhäuser sind regelmäßig aus einer Deckenwand, Seitenwänden und einer Bodenwand aufgebaut, wobei die Wände durch eine Mehrzahl von miteinander verbundenen plattenartigen Wandelementen gebildet sind. Beispielsweise sind derartige plattenartige Wandelemente durch Sandwichplatten gebildet, die jeweils aus einer stabilen Außenhaut und einer stabilen Innenhaut sowie aus einer zwischen der Außenhaut und der Innenhaut liegenden Wärmedämmschicht aufgebaut sind. Diese so aufgebauten Instrumentenschutzhäuser haben gegenüber einer herkömmlichen Ziegelbauweise bzw. einem Fertigbau in Beton z. B. den Vorteil, dass sie ein niedrigeres Gesamtgewicht aufweisen, was die Aufstellung in und auf Gebäuden und/oder Stahlbaukonstruktionen erlaubt. Des weiteren sind derartige Instrumentenschutzhäuser komplett transportabel und können in der Werkstatt fertig ausgerüstet werden, z. B. mit Heizungen, Klimatisierungen, Elektroinstallationen, Beleuchtungen, Rohr- und Kabeldurchführungen, Montagesystemen, etc. Gegenüber der herkömmlichen Ziegelbauweise und dem Fertigbetonbau ergeben sich hierdurch erhebliche Kosteneinsparungen von bis zu 2/3 der Gesamtkosten.

Insbesondere bei der Verwendung derartiger Instrumentenschutzhäuser bzw. Schutzgehäuse in solchen Klimazonen, in denen sehr hohe Temperaturschwankungen gegeben sind, besteht die Gefahr, dass es zu einer unerwünschten Kondensatbildung im Innenraum des Schutzgehäuses bzw. Instrumentenschutzhauses kommen kann, was wiederum die darin angeordneten elektrischen Instrumente und Analysegeräte beschädigen bzw. bezüglich ihrer Messergebnisse negativ beeinflussen kann.

Aus der gattungsbildenden WO 99/08354 ist bereits ein schrankartiges Gehäuse zur Aufnahme von wärmeerzeugenden, elektrischen und/oder elektronischen Baueinheiten bekannt. Zur Wärmeabfuhr aus dem Innenraum sind die Seitenwände doppelwandig ausgebildet und bestehen jeweils aus einer Innenwand und einer Außenwand, zwischen denen ein freier Zwischenraum verbleibt. Die Zwischenräume in den Wänden sind nach unten und nach oben hin offen, d. h. weisen eine Strömungsverbindung zur Umgebung auf, damit bei der Betätigung von Ventilatoren die Umgebungsluft auf der Unterseite der Wände angesaugt wird und oben wieder aus den Wänden austritt. Beim Durchströmen der Zwischenräume nehmen die Luftströme Wärme aus den Innenwänden auf und transportieren diese Wärme in die Umgebung ab. Die doppelwandigen Seitenwände sind durch Hohlkammerprofile ausbildende Aluminium-Strangprofile ausgebildet. Zusätzlich zu diesem sogenannten externen Kühlkreislauf kann im Innenraum des Gehäuses auch noch ein zweiter interner Kühlkreislauf installiert sein, der von dem externen Kühlkreislauf strömungsmäßig vollständig getrennt ist. Ein Nachteil dieses Aufbaus ist jedoch, dass dieser insbesondere bei sehr hohen Außenumgebungstemperaturen, wie dies in heißen Klimazonen der Fall sein kann, nicht mit dem gewünschten Effekt zu betreiben ist, so dass derartige Instrumenten-Schutzgehäuse nur beschränkt einsetzbar sind. Um diesem Problem wenigstens zum Teil zu begegnen, ist ferner vorgesehen, die Außenwände mit einem reflektierende Pigmente enthaltenden Lackpulver zu beschichten, um die äußere Aufwärmung des Gehäuses durch Sonneneinstrahlung zu verringern.

Ein ähnlicher Aufbau ist auch aus der DE 295 19 260 U1 in Verbindung mit einem witterungsgeschützten Elektronik-Schaltschrank bekannt, bei dem der doppelwandige Aufbau jedoch mittels einer den Schaltschrank umgebenden Schutzhaube erreicht wird. Konkret ist hier in einer Ausführungsform ein einzelner Wärmetauscher so in den Aufbau integriert, dass ein wärmeaufnehmender Wärmetauscherteil im Schrank selbst und ein wärmeabgebender Wärmetauscherteil im Schutzdach liegt. Die Luft als Wärmetausch-Medium wird hierbei über Ventilatoren durch den Aufbau gesaugt. Auch mit einem derartigen Aufbau ist insbesondere in solchen Klimazonen, in denen insbesondere tagsüber sehr hohe Temperaturen vorliegen, keine zufriedenstellende Klimatisierung eines Innenraums des Schutzgehäuses möglich, so dass es zu einer unerwünschten Kondensatbildung im Innenraum des Schutzgehäuses kommen kann.

Aufgabe der Erfindung ist es daher, ein Instrumenten-Schutzgehäuse, insbesondere ein Instrumentenschutzhaus für elektrische Instrumente und Analysegeräte, zu schaffen, das vielseitig und universell einsetzbar ist und mit dem eine sehr gute Klimatisierung des Innenraums des Instrumenten-Schutzgehäuses, insbesondere zur Bereitstellung einer im Wesentlichen konstanten Instrumentenumgebungstemperatur im Innenraum des Schutzgehäuses erzielt werden kann.

Diese Aufgabe wird gelöst mit den Merkmalen des Anspruchs 1. Vorteilhafte Ausgestaltungen sind Gegenstand der Unteransprüche.

Gemäß Anspruch 1 ist vorgesehen, dass wenigstens ein Teilbereich der Gehäusewand, vorzugsweise eine sogenannte Sandwichwand mit einer stabilen Außen- und Innenwand und einer dazwischen angeordneten Isolierschicht aus z. B. PU-Material, als Wärmetauscher-Wandbereich ausgebildet ist, wobei in den Wärmetauscher-Wandbereich, im Falle einer Sandwichwand in die Isolierschicht, ein interner Wärmetauscher integriert ist, mittels dem im Innenraum des Schutzgehäuses lediglich ein Wärmeaustausch mit dem Innenraum des Schutzgehäuses durchführbar ist. Dieser wenigstens eine interne Wärmetauscher ist mit einem externen Wärmetauscher, mittels dem lediglich ein Wärmeaustausch mit der Außenumgebung des Schutzgehäuses durchführbar ist, strömungsverbunden, wobei die miteinander strömungsverbundenen, vorzugsweise jedoch voneinander thermisch entkoppelten internen und externen Wärmetauscher jeweils ein vorgegebenes Aufnahmevolumen für eine vorgegebene Menge einer zwischen diesen zu vorgegebenen Zeitpunkten in einem nach außen abgeschlossenen System zirkulierbaren Wärmetausch-Flüssigkeit, insbesondere Wasser, aufweisen. Die Flüssigkeit weist vorteilhaft eine hohe Wärmekapazität auf, z. B. eine größere Wärmekapazität als die Luft, was zu sehr guten Wärmetausch-Ergebnissen führt.

Mit diesem Aufbau wird erreicht, dass sich z. B. bei Wasser als Wärmeaustausch-Flüssigkeit und einer Außenumgebungstemperatur, die unter die Wassertemperatur in den Wärmetauschern fällt, durch die Abkühlung des Wassers im externen Wärmetauscher ein natürlicher Kreislauf ausbildet, mit dem kälteres Wasser von dem externen Wärmetauscher in den internen Wärmetauscher überströmt, so dass dieser wiederum einen Wärmeaustausch mit dem Innenraum des Schutzgehäuses ausführen kann. Dies ist z. B. in sehr heißen Regionen nachts der Fall. Tagsüber, wenn sehr heiße Außenumgebungstemperaturen herrschen, ist dagegen das Wasser als Wärmetausch-Medium im externen Wärmetauscher so heiß, dass keine Zirkulation stattfindet. Die externen und internen Wärmetauscher speichern dabei das Wasser in der Art eines Schichtspeichers ein, und zwar dergestalt, dass kaltes Wasser, welches schwerer als warmes Wasser ist, absinkt, während dagegen warmes Wasser aufsteigt. Dementsprechend werden in den externen und internen Wärmetauschern unterschiedliche Schichtbereiche bzw. Temperaturzonen ausgebildet.

Mit einem derartigen Aufbau eines Schutzgehäuses bzw. Instrumentenschutzhauses kann auf besonders einfache und vorteilhafte Weise eine konstante Temperatur im Innenraum des Schutzgehäuses erzielt bzw. aufrechterhalten werden, und zwar insbesondere auch in solchen Klimaregionen, in denen erhebliche Temperaturschwankungen gegeben sind, z. B. sehr hohe Tagestemperaturen und demgegenüber sehr niedrige Nachttemperaturen, wie dies z. B. in Wüstenregionen der Fall ist. Auch kurzfristig auftretende Temperaturspitzen können hier sehr gut mit einem derartigen Wärmetauscher-Wandsystem abgebaut werden. Dadurch kann somit auf einfache Weise vermieden werden, dass die im Inneren angeordneten Instrumente und Geräte über deren zulässige Maximaltemperatur erhitzt werden. Besonders vorteilhaft ist hier die Integration der jeweiligen Aufnahmevolumina in die Isolierschicht der sogenannten Sandwichelemente bzw. Sandwichplatten, da dies auf einfache und preiswerte Weise bereits bei der Herstellung derartiger Elemente erfolgen kann und somit nicht erst am Aufstellungsort des z. B. Instrumentenschutzhauses als nachträgliche Maßnahme vorgenommen werden muss. Entsprechendes gilt auch für einen Aufbau eines Schutzkastens, der auf der Innenseite sandwichartig mit einer Isolierschicht ausgekleidet ist, auf der eine stabile Innenhaut wenigstens bereichsweise aufgebracht ist.

Gemäß einer ersten konkreten Ausführungsform ist der externe Wärmetauscher außerhalb des Schutzgehäuses angeordnet, z. B. auf dem Dach eines Instrumentenschutzhauses und über entsprechende Rohrleitungen mit dem in einen Wärmetauscher-Wandbereich der Gehäusewand integrierten internen Wärmetauscher strömungsverbunden. Diese Strömungsverbindung zwischen dem externen und dem internen Wärmetauscher findet bevorzugt unter Zwischenschaltung eines z. B. Wassertanks als Zwischenspeicher statt, der z. B. im Dachbereich des Instrumentenschutzhauses bzw. Schutzgehäuses aufgenommen ist, und zwar z. B. in einem separaten Zwischenspeicher-Aufnahmeraum. Hier kann entweder der Zwischenspeicher selbst oder der Aufnahmeraum entsprechend thermisch isoliert sein. Dieser Zwischenspeicher, der einerseits mit dem internen Wärmetauscher und andererseits mit dem externen Wärmetauscher strömungsverbunden ist, ist bezüglich seines Volumens so ausgelegt, dass ein für einen Wärmetausch optimales Volumen einer Wärmetausch-Flüssigkeit zur Verfügung gestellt wird und kann je nach den entsprechenden Einsatzorten und Einsatzbedingungen variieren.

Gemäß einer weiteren konkreten und diesbezüglich alternativen Ausführungsvariante ist der wenigstens eine externe Wärmetauscher ebenfalls in die Gehäusewand, vorzugsweise in eine Sandwichwand des Schutzgehäuses integriert. Für den Fall, dass das Schutzgehäuse bzw. das Instrumentenschutzhaus aus einer Mehrzahl von miteinander verbundenen plattenartigen Wandelementen, vorzugsweise von Sandwichelementen mit einer stabilen Außen- und Innenwand sowie einer dazwischen liegenden Isolierschicht, z. B. aus PU-Schaum, ausgebildet ist, von denen wenigstens eines als Wärmetauscher-Wandelement mit integriertem internen Wärmetauscher ausgebildet ist, ist der externe Wärmetauscher vorzugsweise zusammen mit dem internen Wärmetauscher in dieses Wärmetauscher-Wandelement bzw. vorzugsweise das Wärmetauscher-Sandwichelement, und zwar im lsolierschichtbereich, integriert. In diesem Wärmetauscher-Wandelement können Mittel angeordnet sein, mittels denen der externe Wärmetauscher von dem internen Wärmetauscher unter Berücksichtigung einer Strömungsverbindung zwischen den beiden Wärmetauschern thermisch isoliert ist. Bevorzugt ist hierbei das Wärmetauscher-Wandelement als Wärmetauscher-Sandwichelement zweikammrig mit einer die beiden Wärmetauscher ausbildenden ersten Hohlkammer und zweiten Hohlkammer ausgebildet, die voneinander im Inneren des Wärmetauscher-Wandelementes mittels einer die beiden Hohlkammern voneinander thermisch isolierenden Zwischenwand abgetrennt sind. Mit einem derartigen Aufbau wird eine sehr vorteilhafte Funktionsintegration erreicht, da hier die beiden Wärmetauscher in ein einziges plattenartiges Wandelement integriert werden können. Die beiden Hohlkammern und damit die beiden Wärmetauscher sind bevorzugt jeweils großvolumig und sich über einen vorgegebenen Teilbereich der Fläche des Wärmetauscher-Wandelementes erstreckend ausgebildet, wobei - auch bezogen auf sämtliche zuvor und nachfolgend beschriebenen Ausführungsformen - das Aufnahmevolumen des internen Wärmetauschers bevorzugt größer ist als das Aufnahmevolumen des externen Wärmetauschers.

Grundsätzlich könnte aber auch einer der Wärmetauscher in einem ersten Wandelement und der andere Wärmetauscher in einem zweiten Wandelement, d. h. z. B. in unterschiedlichen Sandwichplatten, ausgebildet sein, wobei dann zwischen diesen vorzugsweise angrenzenden Wandelementen eine Strömungsverbindung herzustellen wäre. Die Größe der jeweiligen den internen und externen Wärmetauscher ausbildenden Aufnahmeraumvolumina für die Wärmetausch-Flüssigkeit, vorzugsweise Wasser, hängt dabei von den jeweils konkret gegebenen Bedingungen, wie z. B. der Größe des Instrumentenschutzhauses bzw. der erforderlichen Wärmetauschleistung ab. Vorteilhaft ist jedoch hier ein Aufbau, bei dem der interne Wärmetauscher gleichzeitig auch die Funktion als Wassertank übernimmt, so dass z. B. das Volumen des internen Wärmetauschers größer ausgebildet sein kann als das Volumen des externen Wärmetauschers. Des weiteren ist hier zu beachten, dass das Temperaturniveau der einzelnen Schichtungen in den jeweiligen Wärmetauschern erheblich von dem erforderlichen Wärmeaustausch des externen Wärmetauschers mit der Außenumgebung des Schutzgehäuses bzw. des internen Wärmetauschers mit dem Innenraum des Schutzgehäuses abhängt. Weiter kann vorgesehen sein, dass das Wärmetauscher-Wandelement rechteckförmig ausgebildet ist und ist zur Ausbildung eines Paares von in Hochachsenrichtung gesehen oberen und unteren Überströmverbindungen jeweils eine Überströmverbindung in den Eckbereichen der isolierenden Zwischenwand vorgesehen.

Weiter können sich die beiden Aufnahmevolumen der Wärmetauscher in einer quer zur Hochachsenrichtung verlaufenden Breitenerstreckungsrichtung des Wärmetauscher-Wandelementes wenigstens über einen vorzugsweise gleichen Teilbereich erstrecken. Insbesondere können sich das den internen Wärmetauscher bildende erste Aufnahmevolumen und das den externen Wärmetauscher bildende zweite Aufnahmevolumen in Hochachsenrichtung des Wärmetauscher-Wandelementes gesehen lediglich über einen vorgegebenen Teilbereich der Gesamthöhe des Wärmetauscher-Wandelementes erstrecken, so dass der externe Wärmetauscher in Hochachsenrichtung gesehen wenigstens zum Teil oberhalb des internen Wärmetauschers liegt, so dass sich die beiden Aufnahmevolumen des externen Wärmetauschers und des internen Wärmetauschers auf gegenüberliegenden Seiten der isolierenden Zwischenwand diagonal zueinander versetzt gegenüberliegen. Besonders bevorzugt überlappen sich der interne Wärmetauscher und der externe Wärmetauscher wenigstens bereichsweise in wenigstens einem Überlappungsbereich, wobei in diesem wenigstens einen Überlappungsbereich die wenigstens eine in etwa horizontal ausgerichtete Strömungsverbindung zwischen den beiden Wärmetauschern hergestellt ist. Gemäß einer ersten Alternative liegt wenigstens eine der Strömungsverbindungen in etwa auf Höhe eines mittleren Wärmetauscher-Wandelementbereiches, wobei die wenigstens eine Strömungsverbindung bezogen auf die Breitenerstreckung des Wärmetauscher-Wandelementes randseitig in einem im jeweiligen Wärmetauscher mittels einer Trennwand vom Restvolumen des Wärmetauschers abgetrennten Einströmkanal angeordnet ist. In diesem Fall erstreckt sich die Trennwand in Hochachsenrichtung gesehen bis in den jeweiligen Kalt- bzw. Warmwasserschichtbereich und weist dort einen Überströmspalt in das Restvolumen des jeweiligen Wärmetauschers auf. Alternativ zu dieser eben beschriebenen Ausführungsform kann aber auch vorgesehen sein, dass wenigstens eine der Strömungsverbindungen in einem vom jeweiligen Aufnahmevolumen des internen bzw. externen Wärmetauschers abgezweigten Ausströmkanal ausgebildet ist, der sich in einem an den jeweiligen Wärmetauscher angrenzenden Vollmaterialwandbereich bis in den Bereich des jeweils anderen Aufnahmevolumen des externen bzw. internen Wärmetauschers erstreckt. Dadurch erstreckt sich ein auf der Seite des externen Wärmetauschers angeordneter Ausströmkanal von dessen Kaltbereich weg in Hochachsenrichtung gesehen nach unten in Richtung Kaltbereich des internen Wärmetauschers. Zudem erstreckt sich hier dann ein auf der Seite des internen Wärmetauschers angeordneter Ausströmkanal von dessen Wärmebereich weg in Hochachsenrichtung gesehen nach oben in Richtung Warmbereich des externen Wärmetauschers. Bevorzugt ist der jeweilige Ausströmkanal des jeweiligen Wärmetauschers jeweils randseitig und in etwa geradlinig verlaufend ausgebildet, wobei die jeweilige in dem Ausströmkanal ausgebildete Strömungsverbindung dort bevorzugt jeweils endseitig am freien Ende angeordnet ist. In Verbindung mit den eben beschriebenen Ausgestaltungen ist vorteilhaft vorgesehen, dass der auf beiden Seiten der isolierenden Zwischenwand liegende Vollmaterialbereich, der die Wärmetauscher begrenzt, durch isolierendes Material gebildet ist, vorzugsweise durch Isolierblöcke, die den Freiraum zwischen den Stirnseiten, der Außen- bzw. Innenwand und der Zwischenwand unter Freilassung des Aufnahmevolumens der Wärmetauscher ausfüllen und die entweder integral mit der Zwischenwand oder als separate Bauteile ausgebildet sind.

Neben einem natürlichen Kreislauf können selbstverständlich begleitend oder aber auch insgesamt Hilfsmittel wie z. B. elektrische Pumpen oder dergleichen vorgesehen sein, mit denen ein Kreislauf zwischen dem externen und dem internen Wärmetauscher unabhängig von natürlichen Parametern eingestellt werden kann.

Um sicherzustellen, dass - bei Wasser als verwendeter Flüssigkeit - stets nur eine Einschichtung von kaltem Wasser aus dem Kaltbereich des externen Wärmetauschers in den Kaltbereich des internen Wärmetauschers und eine Einschichtung von warmen Wasser aus dem Warmbereich des internen Wärmetauschers in den Warmbereich des externen Wärmetauschers erfolgt, können zudem im Bereich der Strömungsverbindungen bzw. Überströmöffnungen allgemein bekannte Rückschlagventile und/oder elektrisch betätigte Ventile vorgesehen sein.

Weitere detaillierte Ausgestaltungen bzw. Vorteile finden sich in der nachfolgenden Figurenbeschreibung in Verbindung mit konkreten Ausführungsbeispielen.

### Es zeigen:

- Fig. 1: eine schematische Vorderansicht einer ersten Ausführungsform eines erfindungsgemäßen Instrumentenschutzhauses,
- Fig. 2: einen schematischen Längsquerschnitt durch ein Wärmetauscher-Wandelement des Instrumentenschutzhauses entlang der Linie Z-Z der Fig. 1,
- Fig. 3: eine schematische perspektivische Darstellung einer alternativen Ausführungsform eines erfindungsgemäßen Instrumentenschutzhauses,

- Fig. 4: eine schematische Außenansicht eines Wärmetauscher-Wandelementes des Instrumentenschutzhauses der Fig. 3 mit nicht dargestellter Außenwand,
- Fig. 5: eine schematische Innenansicht eines Wärmetauscher-Wandelementes des Instrumentenschutzhauses der Fig. 3 mit nicht dargestellter Innenwand,
- Fig. 6: einen schematischen Querschnitt entlang der Linie A-A der Fig. 4 und 5,
- Fig. 7: einen schematischen Querschnitt entlang der Linie B-B der Fig. 4 und 5,
- Fig. 8: einen schematischen Querschnitt entlang der Linie C-C der Fig. 4 und 5,
- Fig. 9: einen schematischen Querschnitt entlang der Linie D-D der Fig. 4 und 5,
- Fig. 10: einen schematischen Querschnitt entlang der Linie E-E der Fig. 4 und 5,
- Fig. 11: eine aufgebrochene, schematische und perspektivische Darstellung des Wärmetauscher-Wandelementes gemäß der Fig. 4 bis 10,
- Fig. 12: eine schematische Innenansicht einer zum Wandelement der Fig. 4 bis 11 alternativen Ausführungsform eines Wandelementes,

- Fig. 13: eine schematische Außenansicht einer weiteren zum Wandelement der Fig. 4 bis 11 alternativen Ausführungsform eines Wandelementes,
- Fig. 14: eine schematische Außenansicht eines weiteren alternativen Wärmetauscher-Wandelementes mit nicht dargestellter Außenwand,
- Fig. 15: einen schematischen Querschnitt entlang der Linie F-F der Fig. 14, und
- Fig. 16: eine schematische, geschnittene Seitenansicht einer weiteren erfindungsgemäßen Ausführungsform eines als Schutzkasten ausgebildeten Schutzgehäuses ohne externe Wärmetauscher.

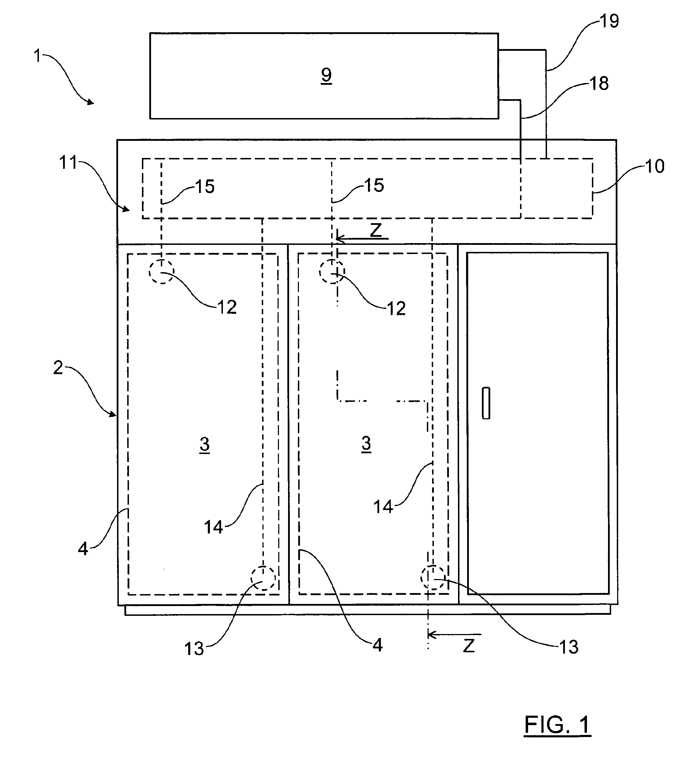

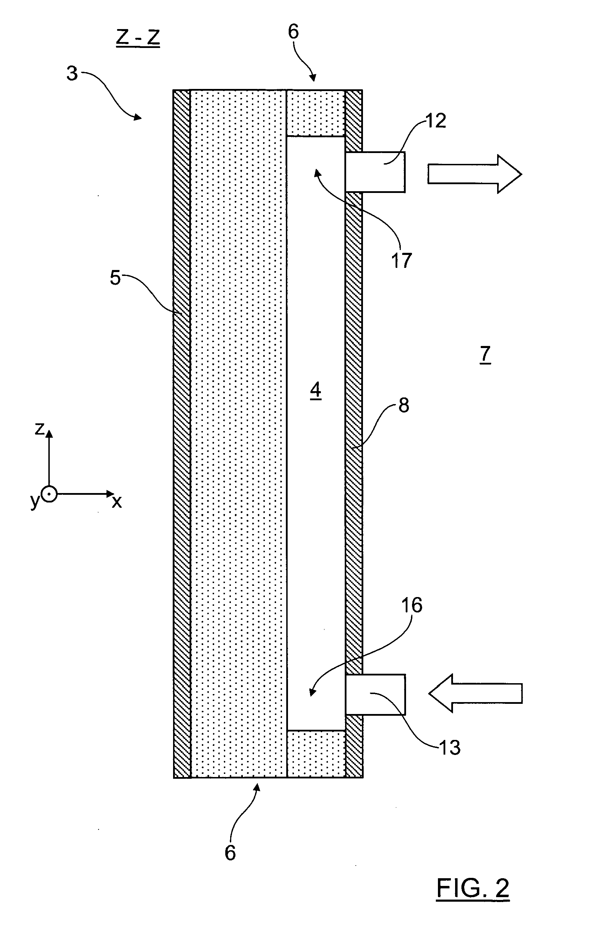

In den Fig. 1 und 2 ist schematische eine erste Ausführungsform eines erfindungsgemäßen Instrumentenschutzhauses 1 dargestellt, das im Seitenwandbereich 2 durch eine Mehrzahl von miteinander verbundenen sandwichartig aufgebauten Wandelementen 3, sogenannten Sandwichplatten mit stabiler Außen- und Innenhaut sowie dazwischenliegender Isolierschicht ausgebildet ist. Eines bzw. einzelne oder jedes dieser Wandelemente 3 kann als Wärmetauscher-Wandelement bzw. Wärmetauscher-Sandwichplatte ausgebildet sein, in dessen Isolierschicht, wie dies insbesondere der Fig. 2 zu entnehmen ist, die einen Längsschnitt entlang der Linie Z-Z durch ein derartiges Wärmetauscher-Wandelement 3 zeigt, ein in der Fig. 1 strichliert eingezeichnetes Aufnahmevolumen als interner Wärmetauscher 4 integriert ist. Dieser in das Wärmetauscher-Wandelement 3 integrierte interne Wärmetauscher 4 ist, wie dies insbesondere der Fig. 2 zu entnehmen ist, zu einer Außenwand 5 sowie zu den umlaufenden Stirnseiten 6 hin mittels einem die Isolierschicht ausbildenden Isoliermaterial, z. B. einem Polyurethan-Schaummaterial, thermisch isoliert. Die Außenwand selbst kann z. B. aus Aluminium hergestellt sein.

Das Aufnahmevolumen des internen Wärmetauschers 4 ist zum Innenraum 7 des Instrumentenschutzhauses 1 hin von einer Innenwand 8 begrenzt, die z. B. ebenfalls aus Aluminium gebildet ist, um einen Wärmeübergang zwischen dem Innenraum 7 und dem internen Wärmetauscher 4 zu ermöglichen.

Wie dies insbesondere der Fig. 1 entnommen werden kann, ist dieser in den Wärmetauscher-Wandelementen 3 ausgebildete und integrierte interne Wärmetauscher 4 mittels einem z. B. auf dem Dach des Instrumentenschutzhauses 1 angeordneten externen Wärmetauscher 9 unter Zwischenschaltung eines Wassertanks 10 strömungsverbunden. Der Wassertank 10 ist als Zwischenspeicher in einem im Dachbereich des Instrumentenschutzhauses 1 ausgebildeten separaten Aufnahmeraum 11 aufgenommen.

Das Wasser als Wärmetausch-Medium wird sowohl in den internen Wärmetauscher 4 als auch in den externen Wärmetauscher 9 und in den Wassertank 10 in der Art eines Schichtspeichers in einzelnen Temperaturbereichen bzw. -zonen eingespeichert, wobei schwereres, kaltes Wasser im unteren Bereich und demgegenüber leichteres, warmes Wasser in einem oberen Bereich der Wärmetauscher 4, 9 bzw. des Wassertankes 10 eingespeichert wird. Dementsprechend weist jedes Wärmetauscher-Wandelement 3 in Hochachsenrichtung gesehen wenigstens einen oberen Anschlussstutzen 12 sowie wenigstens einen unteren Anschlussstutzen 13 auf, die jeweils in den internen Wärmetauscher 4 münden und über entsprechende Rohrleitungen 14, 15 mit dem Wassertank 10 strömungsverbunden sind. Der untere Kaltwasserbereich 16 des internen Wärmetauschers 4 ist dabei über den unteren Anschlussstutzen 13 und die Rohrleitung 14 als Kaltleitung mit einem Kaltbereich des Wassertanks 10 verbunden, während ein oberer Warmwasserbereich 17 des internen Wärmetauschers 4 über die Rohrleitung 15 als Warmleitung mit einem Warmbereich des Wassertanks 10 verbunden ist. Ebenso ist der Kaltwasserbereich des Wassertanks 10 mit dem Kaltwasserbereich des externen Wärmetauschers 9 und der Warmwasserbereich des Wassertanks 10 mit dem Warmwasserbereich des externen Wärmetauschers 9 strömungsverbunden, was in der Darstellung der Fig. 1 lediglich schematisch dargestellt ist.

Ohne zusätzliche Hilfsmittel, wie z. B. Pumpen, stellt sich hier z. B. bei der Aufstellung eines derartigen Instrumentenschutzhauses 1 in sehr heißen Gegenden am Tag keine Zirkulation ein, da das Wasser im oberen Wärmetauscher so heiß ist, dass sich kein natürlicher Kreislauf mit dem Wassertank 10 ausbildet. Sinkt dagegen nachts die Umgebungstemperatur des Instrumentenschutzhauses, d. h. die Außentemperatur soweit ab, dass ein Wärmeaustausch zwischen dem externen Wärmetauscher 9 und der Umgebung möglich ist, dann sammelt sich im externen Wärmetauscher 9 kühleres Wasser als im Wassertank 10, das über die Kaltleitung 18 in den Kaltwasserbereich des Wassertanks 10 überströmt, während über die Warmleitung 19 Warmwasser aus dem Wassertank 10 in den externen Wärmetauscher 9 überströmt. Sobald sich die Wassertemperatur des Kaltwasserbereiches des Wassertankes 10 unter der Temperatur des Kaltwasserbereichs 16 des internen Wärmetauschers 4 befindet, bildet sich auch zwischen dem Wassertank 10 und dem internen Wärmetauscher 4 ein entsprechender natürlicher Wasserkreislauf aus, bei dem über die Kaltleitung 14 Kaltwasser von dem Wassertank 10 in den Kaltwasserbereich 16 des internen Wärmetauschers 4 überströmt, während über die Warmleitung 15 Warmwasser aus dem Warmwasserbereich 17 des internen Wärmetauschers 4 in den Warmwasserbereich des Wassertanks 10 überströmt. Durch dieses Einschichten von kälterem Wasser in den internen Wärmetauscher 4 wird wiederum ein Wärmeaustausch mit dem Innenraum 7 des Instrumentenschutzhauses 1 ermöglicht, so dass dadurch die Möglichkeit besteht, auch in solchen Temperaturregionen, in denen z. B. sehr hohe Temperaturschwankungen von z. B. 20° und mehr zwischen Tag und Nacht auftreten, eine konstante Instrumentenumgebungstemperatur im Innenraum 7 des Instrumentenschutzhauses 1 aufrecht erhalten werden kann. Dieser natürliche Kreislauf kann auch durch z. B. elektrische Pumpen unterstützt werden, so dass hierdurch der Durchmesser der Rohrleitungen gegebenenfalls vorteilhaft reduziert werden kann. Des weiteren können im Bereich der Überströmöffnungen bzw. Strömungsverbindung zwischen den Rohrleitungen und den entsprechenden Bauteilen allgemein bekannte Rückschlagventile, wie z. B. Membranventile, oder aber auch elektrisch betätigbare Ventile angeordnet sein.

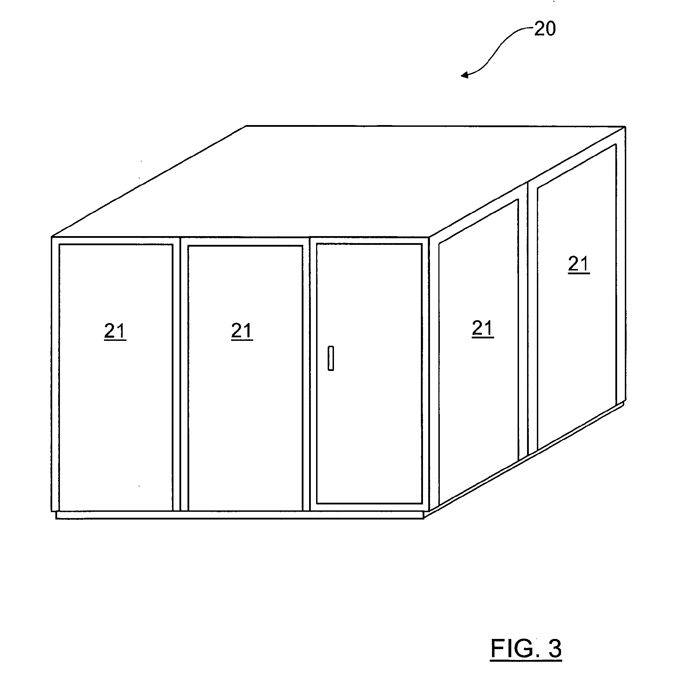

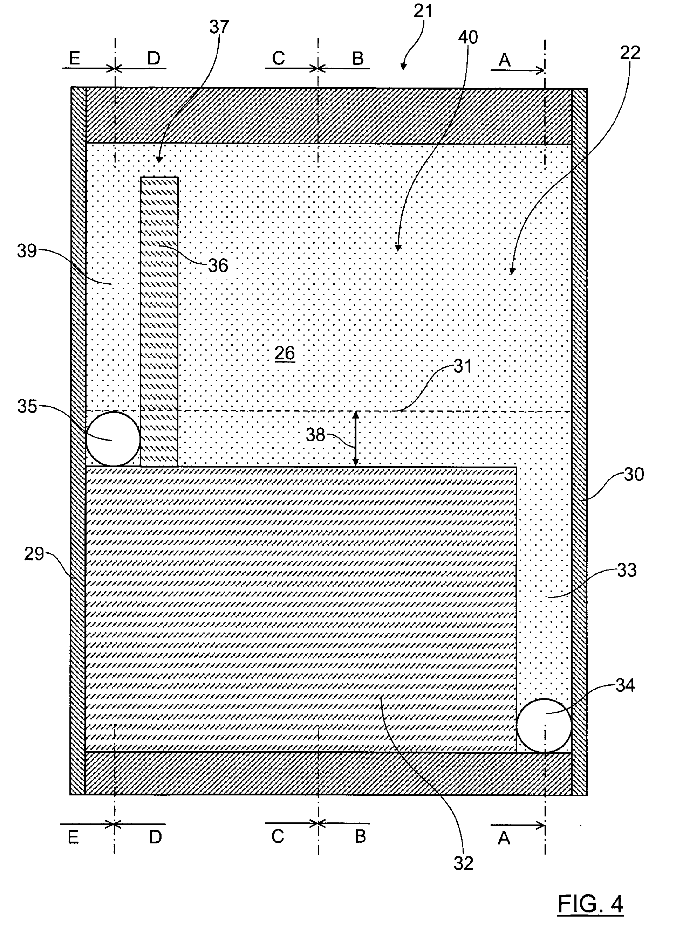

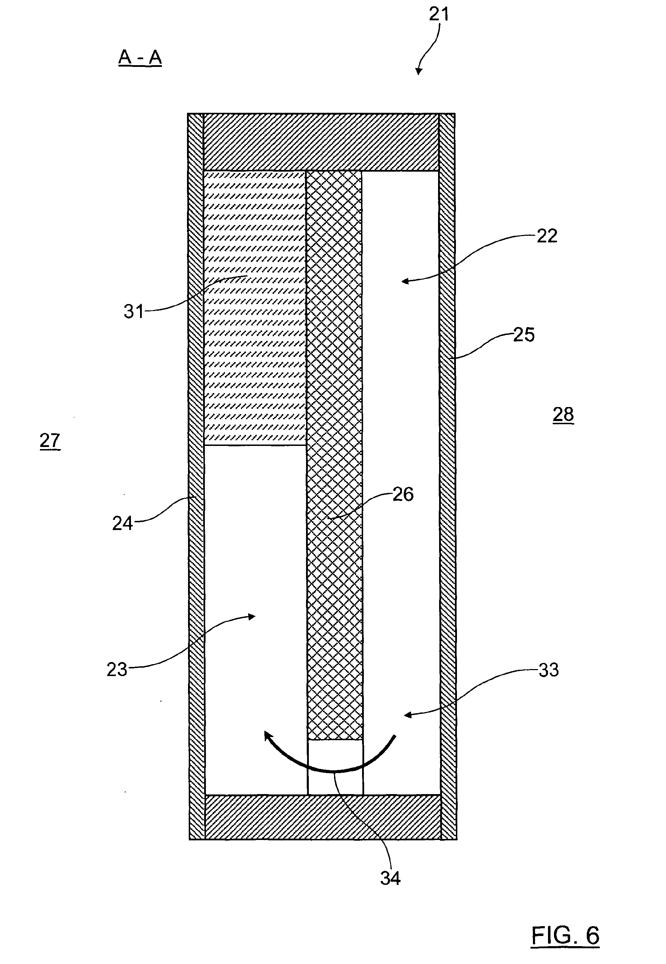

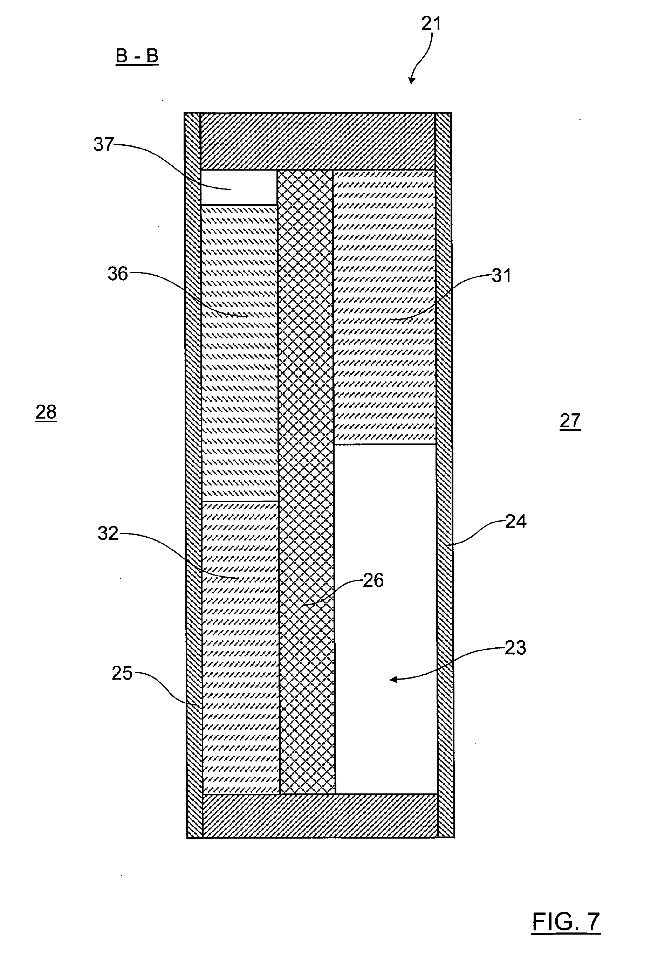

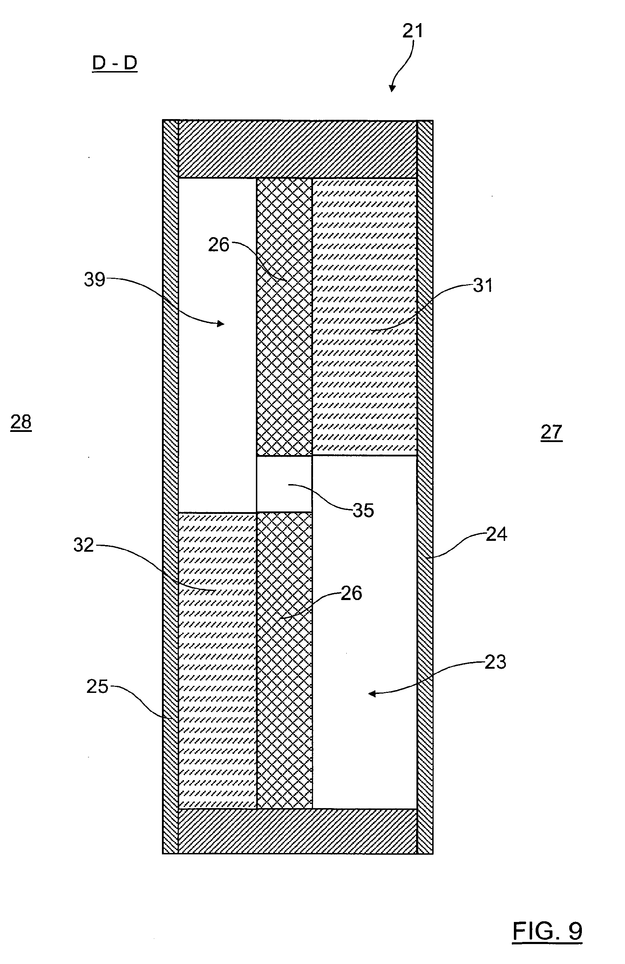

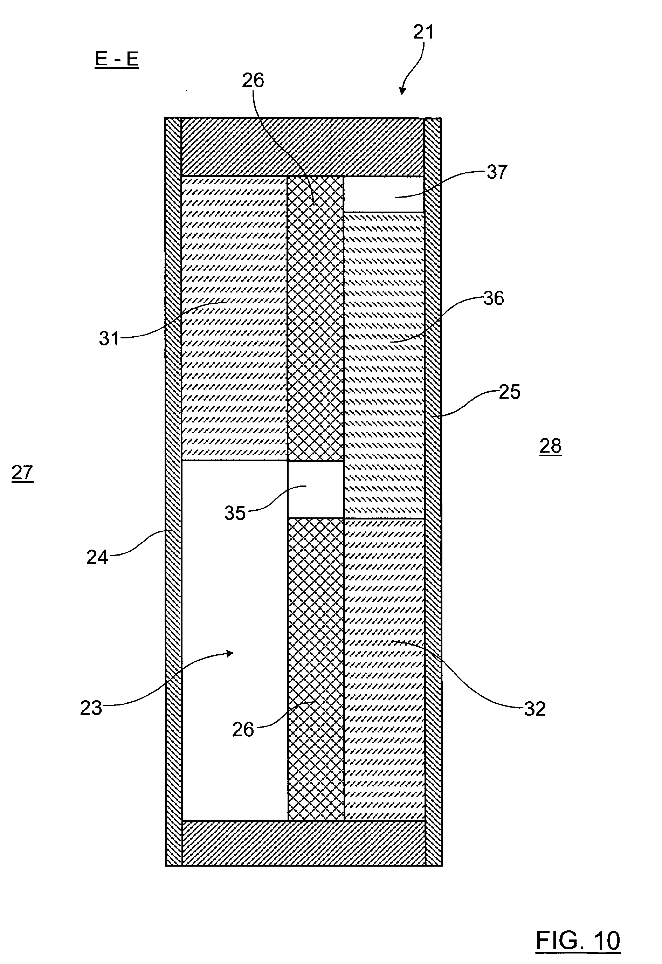

In der Fig. 3 ist eine alternative Ausführungsform eines erfindungsgemäßen Instrumentenschutzhauses 20 gezeigt, bei dem die einzelnen Gehäusewandbereiche, wie dies hier lediglich beispielhaft und schematisch für den Seitenwandbereich dargestellt ist, wiederum durch eine Mehrzahl von miteinander verbindbaren plattenartigen Wandelementen 21 gebildet sind, die wiederum den zuvor in Verbindung mit dem Ausführungsbeispiel der Fig. 1 und 2 näher erläuterten sandwichartigen Aufbau aufweisen. In eines bzw. einzelne oder aber auch jedes dieser Wandelemente kann zur Ausbildung eines Wärmetauscher-Wandelementes bzw. einer Wärmetauscher-Sandwichplatte sowohl ein externer Wärmetauscher 22 als auch ein interner Wärmetauscher 23 integriert sein, wie dies nachfolgend in Verbindung mit den Fig. 4 bis 11 näher erläutert wird:

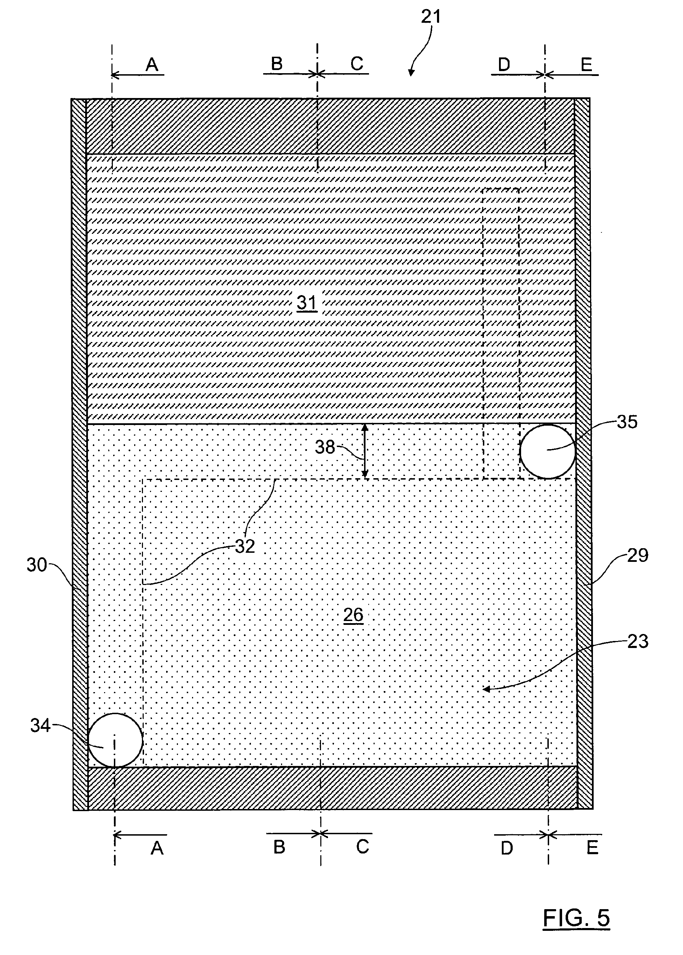

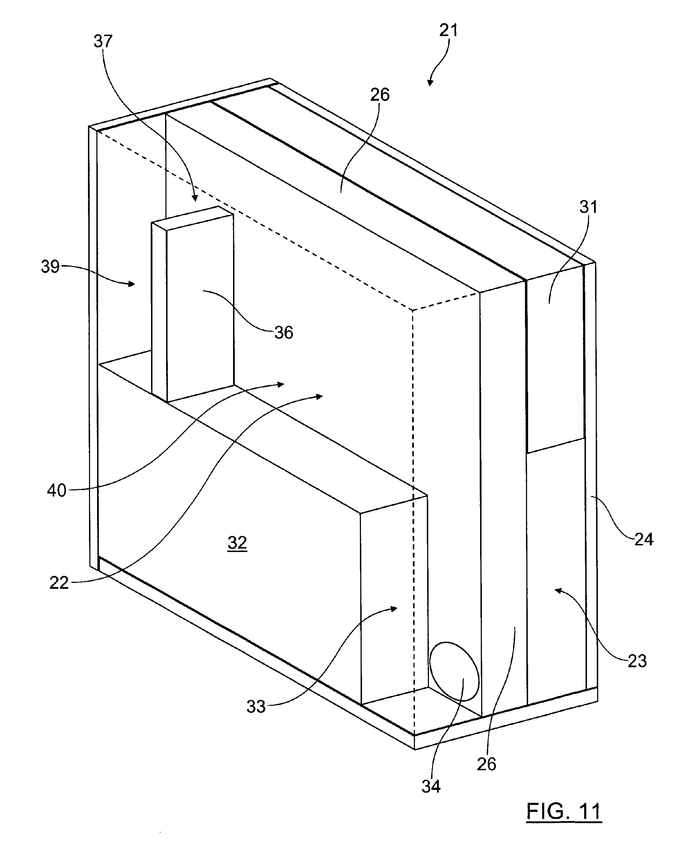

Fig. 4 zeigt eine Draufsicht auf ein Wärmetauscher-Wandelement 21 von der Außenumgebung, d. h. von der Außenseite her, wobei hier zur Verdeutlichung des inneren Aufbaus die Außenwand nicht dargestellt ist. Fig. 5 zeigt eine Innenansicht des Wärmetauscher-Wandelementes 21, wobei auch hier wiederum die Innenwand nicht dargestellt ist. In der Fig. 11 ist schließlich eine äußerst schematische, perspektivische und zum Teil aufgebrochene Darstellung dieser Variante des Wärmetauscher-Wandelementes 21 dargestellt, die lediglich der Übersicht dienen soll und von regelmäßig gewählten Größenverhältnissen abweicht.

Das Wärmetauscher-Wandelement 21 bzw. die Wärmetauscher-Sandwichplatte ist somit zur Ausbildung des externen Wärmetauschers 22 und des internen Wärmetauschers 23 zweikammrig mit auf gegenüberliegenden Seiten einer parallel zu einer Innenwand 24 und einer Außenwand 25 verlaufenden und die beiden Hohlkammern und damit den externen und internen Wärmetauscher 22, 23 voneinander thermisch isolierenden Zwischenwand 26 als Isolierschicht abgetrennt.

Der interne Wärmetauscher 23 wird zum Innenraum 27 des Instrumentenschutzhauses 20 hin durch die Innenwand 24 begrenzt, die z. B. wenigstens bereichsweise aus einem wärmedurchlässigen Material, wie z. B. Aluminium, hergestellt ist. Ebenso ist der externe Wärmetauscher 22 zur Außenumgebung 28 des Instrumentenschutzhauses 20 hin durch die Außenwand 25 begrenzt, die ebenfalls wenigstens in diesem Bereich wenigstens bereichsweise aus einem wärmedurchlässigen Material, wie z. B. Aluminium, hergestellt ist.

Wie dies den Fig. 4 bis 11 weiter entnommen werden kann, sind die beiden Hohlkammern und damit die beiden Wärmetauscher 22, 23 jeweils großvolumig und sich im Wesentlichen über das gesamte Wärmetauscher-Wandelement 21 in Breitenerstreckungsrichtung des Wärmetauscher-Wandelementes 21 gesehen ausgebildet. D. h., dass die Aufnahmevolumina des externen und internen Wärmetauschers 22, 23 in Breitenerstreckungsrichtung durch die stirnseitigen Rahmenteile 29, 30 begrenzt sind. Dabei kann das Aufnahmevolumen des internen Wärmetauschers 23 größer ausgebildet sein als das Aufnahmevolumen des externen Wärmetauschers 22, um in diesem gleichzeitig auch die Funktion des Tanks für die Wärmetausch-Flüssigkeit, vorzugsweise Wasser, zu integrieren.

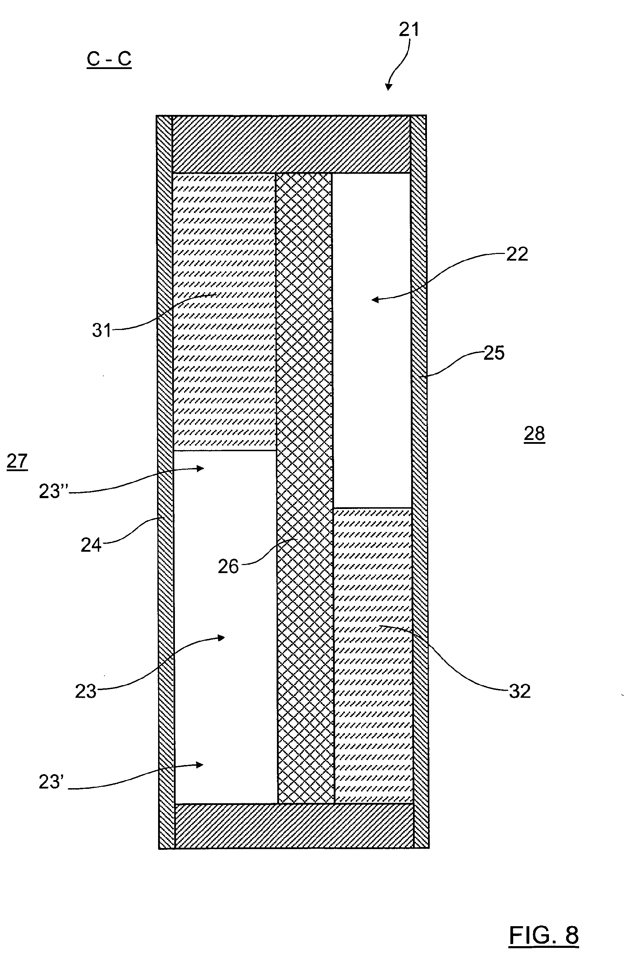

Wie dies insbesondere der Fig. 8 weiter entnommen werden kann, sind der externe Wärmetauscher 22 und der interne Wärmetauscher 23 bezogen auf die Zwischenwand 26 diagonal versetzt zueinander angeordnet, wobei sich das den internen Wärmetauscher 23 bildende erste Aufnahmevolumen in Hochachsenrichtung des Wärmetauscher-Wandelementes 21 gesehen von einem unteren Wärmetauscher-Wandelementbereich ausgehend lediglich bis in etwa einen mittleren Bereich der Gesamthöhe des Wärmetauscher-Wandelementes erstreckt, während sich das den externen Wärmetauscher 22 bildende zweite Aufnahmevolumen auf der gegenüberliegenden Seite der Zwischenwand 26 in Hochachsenrichtung des Wärmetauscher-Wandelementes 21 gesehen von einem oberen Wärmetauscher-Wandelementbereich ausgehend ebenfalls bis in etwa in einem mittleren Bereich der Gesamthöhe des Wärmetauscher-Wandelementes 21 erstreckt. Das Aufnahmevolumen des externen Wärmetauschers 22 bzw. dasjenige des internen Wärmetauschers 23 wird jeweils durch einen in das Wärmetauscher-Wandelement integrierten bzw. als separates Bauteil eingesetzten Isolierblock 31 bzw. 32 begrenzt, der den Raum zwischen der Zwischenwand 26 und der jeweils zugeordneten Innenwand 24 bzw. Außenwand 25 des Wärmetauscher-Wandelementes 21 füllt. Alternativ könnten diese Isolierblöcke aber auch integraler Bestandteil der Zwischenwand 26 sein, was aber hier nicht dargestellt ist. Im Falle des den Bereich zwischen der Außenwand 25 und der Zwischenwand 26 füllenden Isolierblocks 32, der auf der Seite des externen Wärmetauschers 22 liegt, ist dieser Bereich jedoch nicht vollständig ausgefüllt und wird vom Aufnahmevolumen des externen Wärmetauschers 22 ausgehend randseitig ein schmaler Kanalbereich als Ausströmkanal 33 ausgebildet, der in etwa senkrecht sowie randseitig verläuft, wobei dieser Ausströmkanal 33 bezogen auf die Zwischenwand 26 mit dem Aufnahmevolumen des auf der gegenüberliegenden Seite der Zwischenwand 26 liegenden internen Wärmetauschers 23 überlappt. In diesem Ausströmkanal 33 ist im Bereich des unteren Wärmetauscher-Wandelementbereichs eine Überströmverbindung 34 zwischen dem Volumen des externen Wärmetauschers 22 und dem Volumen des internen Wärmetauschers 23 ausgebildet.

Wie dies den Fig. weiter entnommen werden kann, insbesondere den Fig. 4 und 5 mit den strichlierten Darstellungen der hinter der Zwischenwand liegenden Bereiche, überlappen sich die Aufnahmevolumen des externen Wärmetauschers 22 und des internen Wärmetauschers 23 in einem sog. Überlappungsbereich 38, in dem eine weitere Überströmverbindung 35 zur Strömungsverbindung des externen Wärmetauschers 22 mit dem internen Wärmetauscher 23 ausgebildet ist. Auch diese zweite Überströmverbindung 35 ist randseitig angeordnet. Des weiteren erstreckt sich, wie dies insbesondere aus der Fig. 4 weiter ersichtlich ist, im Bereich dieser Überströmverbindung 35 vom Isolierblock 32 ausgehend eine Trennwand 36 unter Ausbildung eines Überströmspaltes 37 in Hochachsenrichtung des Wärmetauscher-Wandelementes 21 gesehen bis in den Bereich des oberen Wärmetauscher-Wandelementbereiches.

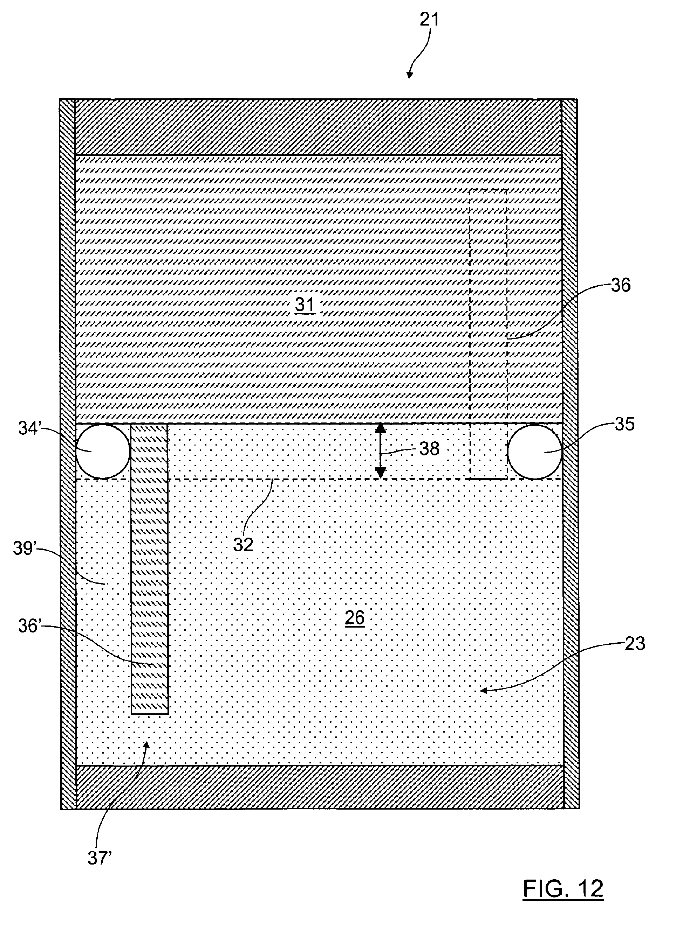

Alternativ zu der hier dargestellten Variante könnten aber auch beide Überströmverbindungen 34, 35 in einem mittleren Höhenbereich des Wärmetauscher-Wandelementes 21 angeordnet sein, wie dies lediglich schematisch und beispielhaft in der Fig. 12 dargestellt ist. In der Fig. 12 ist lediglich eine Innenansicht des Wärmetauscher-Wandelementes 21 gezeigt. In einem solchen Fall ist dann auch auf der Seite des internen Wärmetauschers 23 eine Trennwand 36' entsprechend der Trennwand 36 auf der Seite des externen Wärmetauschers 22 vorzusehen, die sich unter Ausbildung eines Überströmspaltes 37' bis in den unteren Wärmetauscher-Wandelementbereich erstreckt.

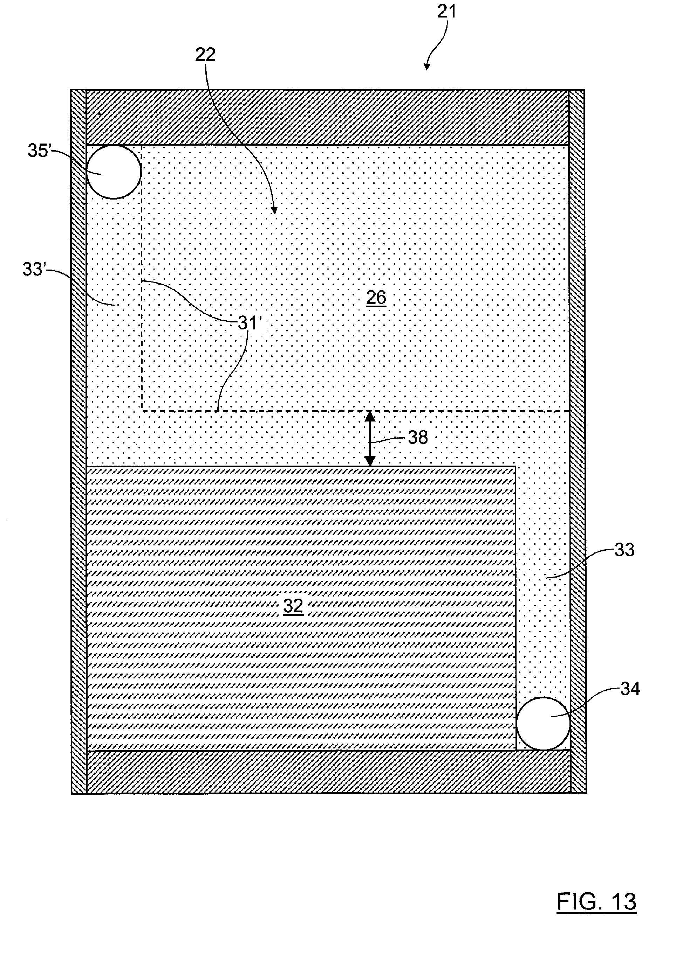

In der Fig. 13 ist eine weitere alternative Ausführungsvariante dargestellt, bei der die beiden Überströmverbindungen 34, 35' jeweils rand- bzw. eckseitig diagonal versetzt gegenüberliegend in jeweils einem Ausströmkanal 33 bzw. 33' angeordnet sind, wie dies zuvor in Verbindung mit der Überströmverbindung 34 detailliert beschrieben worden ist. Auch hier ist nur eine Außenansicht des Wärmetauscher-Wandelementes 21 gezeigt, wobei sich auf beiden Seiten der Zwischenwand 26 ein analoger Aufbau befindet, wie dies in der Fig. 13 strichliert eingezeichnet ist.

Weiter alternativ ist selbstverständlich auch eine Ausführungsvariante möglich, bei der anders als bei der ersten hier geschilderten Variante gemäß den Fig. 4 bis 11 die Überströmverbindung 34 im mittleren Höhenbereich des Wärmetauscher-Wandelementes 21 angeordnet ist mit einer entsprechenden Trennwand 36' auf der Seite des internen Wärmetauschers 23, während auf der Seite des internen Wärmetauschers 23 die Überströmverbindung 35' dann im Ausströmkanal 33' angeordnet wäre.

Wie dies in den Fig. 4 bis 13 lediglich schematisch und beispielhaft dargestellt ist, sind die Überströmverbindungen 34, 35 jeweils in die Zwischenwand 26 integriert und dort z. B. als elektrisch betätigte Ventile bzw. als Rückschlagventile, wie z. B. Membranventile, ausgebildet.

Die Funktionsweise dieser Ausführungsvarianten eines Wärmetauscher-Wandelementes 21 wird nachfolgend anhand der Ausführungsvariante der Fig. 4 bis 11 näher erläutert:

In dem externen Wärmetauscher 22 eingeschichtetes Wasser und hier insbesondere das schwerere, kalte Wasser sinkt über den Ausströmkanal 33 nach unten zur Überströmverbindung 34 ab und wird anschließend auf der gegenüberliegenden Seite der Zwischenwand in den unten liegenden Kaltwasserbereich 23' (Fig. 8) des internen Wärmetauschers 23 eingeschichtet. Entsprechend kann in dem internen Wärmetauscher 23 eingeschichtetes Warmwasser aus dem Warmwasserbereich 23" (Fig. 8) über die Überströmverbindung 35 in den externen Wärmetauscher 22 überströmen, wobei dieses übergeströmte Warmwasser dann entlang des durch die Trennwand 36 ausgebildeten Einströmkanals 39 nach oben aufsteigt und über den Überstromspalt 37 in das Restvolumen 40 des externen Wärmetauschers 22 gelangt und dort eingespeichert wird. Ein derartiger Kreislauf kann sich in der zuvor in Verbindung mit der ersten Ausführungsform geschilderten Art und Weise ausbilden, wenn z. B. die Außenumgebungstemperatur in der Nacht erheblich abfällt und somit ein Wärmeaustausch mit dem Wasser im externen Wärmetauscher 22 erfolgt, bei dem das Temperaturniveau des darin aufgenommenen Wassers abgesenkt wird.

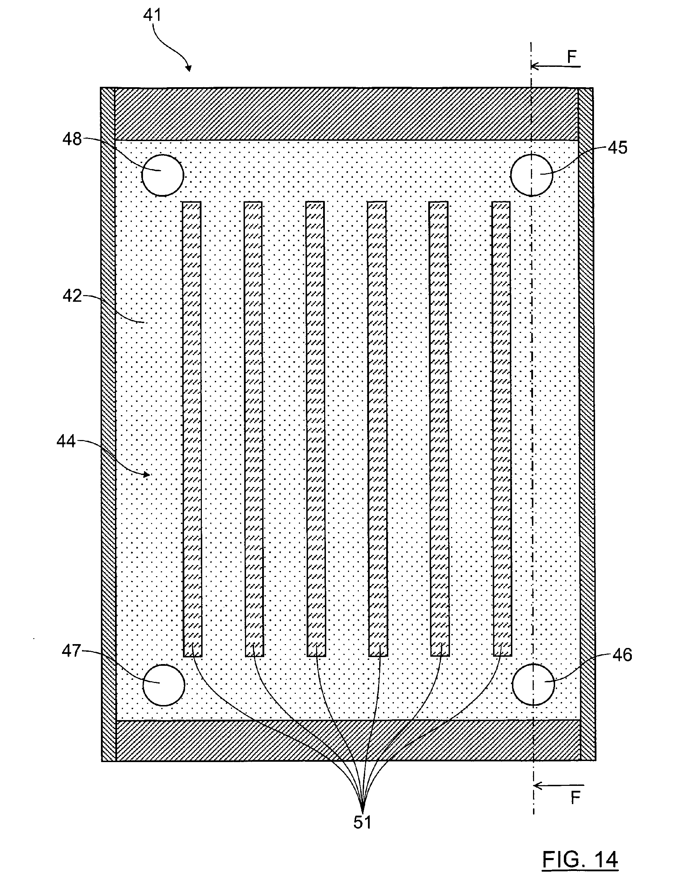

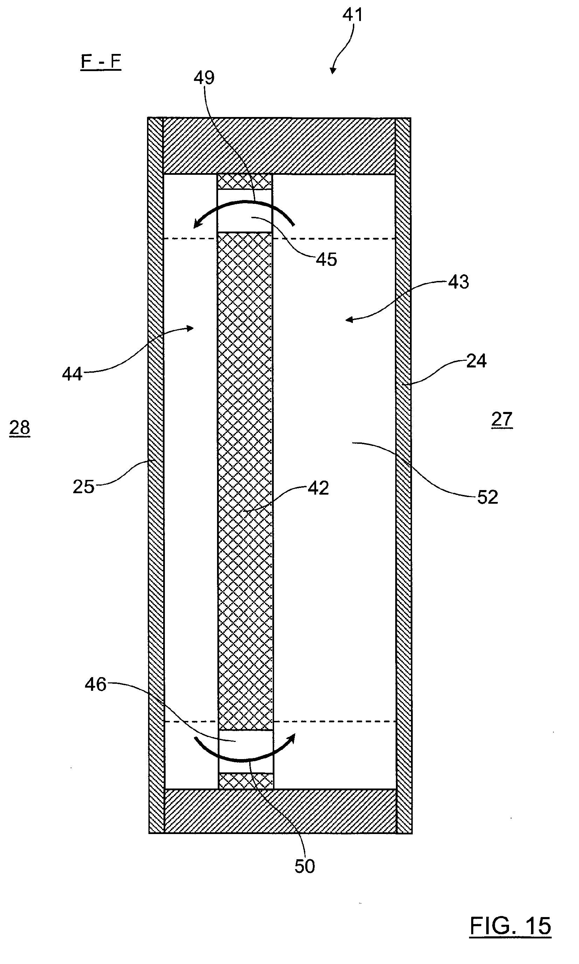

In den Fig. 14 und 15 ist eine weitere alternative Ausführungsform eines Wärmetauscher-Wandelementes 41 dargestellt, bei dem zu beiden Seiten einer Zwischenwand 42 jeweils ein Aufnahmevolumen als Hohlkammer ausgebildet ist, das einerseits einen internen Wärmetauscher 43 und andererseits einen externen Wärmetauscher 44 ausbildet, wobei hier insbesondere aus der Fig. 15 gut ersichtlich ist, dass der interne Wärmetauscher 43 z. B. in Verbindung mit Wasser als Wärmetausch-Medium gleichzeitig auch die Wassertankfunktion übernehmen kann. Über die jeweils eckseitig angeordneten Überströmverbindungen ist auch hier ein entsprechender Kreislauf entweder natürlich oder unterstützt durch Hilfsmittel ausbildbar, wie dies in der Fig. 15 durch die Pfeile 49 bzw. 50 schematisch dargestellt ist.

Zur Stabilisierung des Wärmetauscher-Wandelementes 41 können sowohl im Bereich des internen Wärmetauschers 43 als auch im Bereich des externen Wärmetauschers 44 Versteifungsrippen angeordnet sein, die in der Fig. 15 lediglich strichliert eingezeichnet sind. Ansonsten entspricht die Funktionsweise dieses Wärmetauscher-Wandelements 41 der zuvor beschriebenen Funktionsweise des Wärmetauscher-Wandelementes 21. Derartige Versteifungsrippen können selbstverständlich bei allen Ausführungsvarianten in den Aufnahmevolumina des bzw. der Wärmetauscher vorgesehen sein.

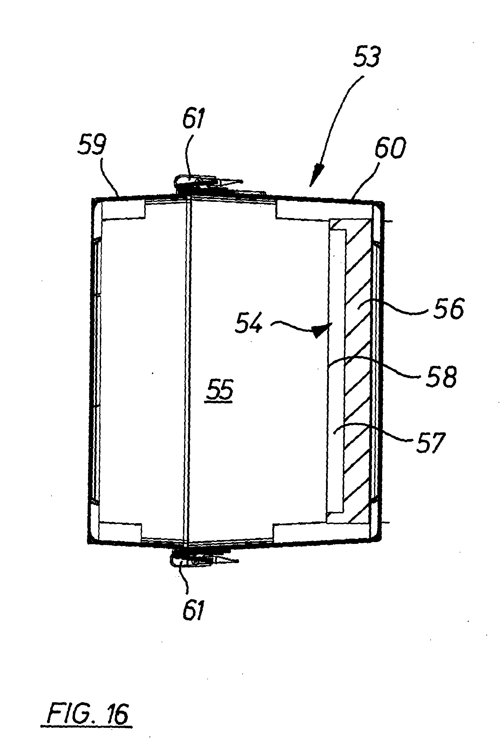

In der Fig. 16 ist schließlich eine schematische, geschnittene Seitenansicht einer weiteren erfindungsgemäßen Ausführungsform eines als Schutzkasten 53 ausgebildeten Schutzgehäuses gezeigt. Wie dieser Querschnitt durch den Schutzkasten 53 zeigt, ist wenigstens ein Teilbereich der Schutzkastenwand als Wärmetauscher-Wandbereich 54 ausgebildet, der auf der dem Innenraum 55 des Schutzkastens 53 zugewandten Innenseite eine Isolierschicht 56 aufweist, die z. B. aus einem Isolierschaum gebildet ist. In dieser Isolierschicht 56 ist, wie dies der Fig. 16 weiter zu entnehmen ist, ein interner Wärmetauscher 57 integriert, der zum Innenraum 55 hin z. B. mit einer Aluminiumfolie 58 als wärmedurchlässige Materialschicht versehen ist. Im Aufnahmevolumen des internen Wärmetauschers 57 ist z. B. Wasser als Kühlmedium aufgenommen bzw. eingeschichtet, das z. B. in Verbindung mit plötzlich in der Schutzkastenumgebung auftretenden Temperaturspitzen die Aufheizung des Innenraums und damit der Instrumentenumgebung vorteilhaft auf einem solchen niedrigen Niveau hält, dass eine kritische Instrumentenumgebungstemperatur nicht erreicht wird.

Wie dies der Fig. 16 weiter entnommen werden kann, ist der Schutzkasten 53 hier zweiteilig aus einer ersten Schutzkastenhälfte 59 und einer zweiten Schutzkastenhälfte 60 aufgebaut, die z. B. über eine hier nicht dargestellte Scharnierverbindung miteinander verbunden sind. Zum Festlegen der beiden Schutzkastenhälften sind herkömmliche Schnellverschlüsse 61 vorgesehen.

Selbstverständlich kann auch der gesamte Innenraum des Schutzkastens 53 mit einem Wärmetauscher-Wandbereich 54 ausgebildet sein. Für viele Einsatzfälle ist jedoch lediglich die Ausbildung eines Teilbereichs als Wärmetauscher-Wandbereich 54 ausreichend.

## Patentansprüche

1. Instrumenten-Schutzgehäuse, insbesondere Instrumentenschutzhaus für elektrische Instrumente und Analysegeräte, mit einer Gehäusewand, wobei wenigstens ein Teilbereich der Gehäusewand als Wärmetauscher-Wandbereich (3; 21; 41; 54) ausgebildet ist, und wobei in den Wärmetauscher-Wandbereich (3; 21; 41; 54) wenigstens ein interner Wärmetauscher (4; 23; 43; 57) integriert ist, mittels dem ein Wärmetausch mit dem Innenraum (7; 27; 55) des Schutzgehäuses (1; 20; 53) durchführbar ist, **dadurch gekennzeichnet,**
**dass** der interne Wärmetauscher (4; 23; 43) mit wenigstens einem externen Wärmetauscher (9; 22; 44), mittels dem ein Wärmetausch mit der Außenumgebung (28) des Schutzgehäuses (1; 20) durchführbar ist, strömungsverbunden ist, und
**dass** die miteinander strömungsverbundenen internen und externen Wärmetauscher (4, 9; 22, 23; 43, 44) jeweils ein vorgegebenes Aufnahmevolumen für eine vorgegebene Menge einer zwischen diesen in einem geschlossenen System zirkulierbaren Wärmetausch-Flüssigkeit, insbesondere Wasser, aufweisen.

2. Instrumenten-Schutzgehäuse nach Anspruch 1, **dadurch gekennzeichnet,**
**dass** die Gehäusewand durch eine Mehrzahl von miteinander verbundenen plattenartigen Wandelementen (3; 21; 41) gebildet ist, und
**dass** wenigstens eines dieser Wandelemente (3; 21; 41) als Wärmetauscher-Wandelement ausgebildet ist, in das als Wärmetauscher-Wandbereich wenigstens ein Wärmetauscher (4, 9; 22, 23; 43, 44) als Aufnahmevolumen für ein Wärmetausch-Medium integriert ist.

3. Instrumenten-Schutzgehäuse nach Anspruch 1 oder 2, **dadurch gekennzeichnet, dass** die Strömungsverbindung zwischen den in der Art eines Schichtspeichers das Wärmetausch-Medium in unterschiedlichen Temperaturzonen einspeichernden bzw. einschichtenden Wärmetauschern (4, 9; 22, 23; 43, 44) so ausgebildet und/oder steuerbar oder regelbar ist, vorzugsweise in Verbindung mit Rückschlagventilen und/oder elektrisch betätigten Ventilen, dass ein Überströmen des Wärmetausch-Mediums von einem Kaltschichtbereich des externen Wärmetauschers (9; 22; 44) in einen Kaltschichtbereich des internen Wärmetauschers (4; 23; 43) sowie ein Überströmen des Wärmetauscher-Mediums von einem Warmschichtbereich des internen Wärmetauschers (4; 23; 43) in einen Warmschichtbereich des externen Wärmetauschers (9; 22; 44) freigegeben ist, die umgekehrte Strömungsrichtung jedoch gesperrt ist.

4. Instrumenten-Schutzgehäuse nach Anspruch 2 oder Anspruch 3, **dadurch gekennzeichnet,**
**dass** der in das Wärmetauscher-Wandelement (3) integrierte interne Wärmetauscher (4) zur Außenwand (5) sowie zu den umlaufenden Stirnseiten (6) hin thermisch isoliert ist, und
**dass** der das Aufnahmevolumen des internen Wärmetauschers (4) zum Innenraum (7) des Schutzgehäuses (1) hin begrenzende Wandbereich durch die Innenwand (8) des Wärmetauscher-Wandelementes (3) gebildet ist, die wenigstens in diesem Bereich aus einem wärmedurchlässigen Material, vorzugsweise Aluminium, gebildet ist.

5. Instrumenten-Schutzgehäuse nach einem der Ansprüche 1 bis 4, **dadurch gekennzeichnet, dass** der externe Wärmetauscher (9) außerhalb des Schutzgehäuses (1) angeordnet ist.

6. Instrumenten-Schutzgehäuse nach einem der Ansprüche 2 bis 5, **dadurch gekennzeichnet, dass** das Wärmetauscher-Wandelement (3) in Hochachsenrichtung des Schutzgehäuses (1) gesehen ein oberes, erstes Anschlusselement (12), vorzugsweise einen oberen, ersten Anschlussstutzen, sowie ein unteres, zweites Anschlusselement (13), vorzugsweise einen unteren, zweiten Anschlussstutzen, aufweist, die einerseits jeweils in den im Wärmetauscher-Wandelement (3) ausgebildeten internen Wärmetauscher (4) als Aufnahmevolumen für das Wärmetauscher-Medium münden, und die andererseits mittelbar oder unmittelbar mit dem externen Wärmetauscher (9) strömungsverbunden sind.

7. Instrumenten-Schutzgehäuse nach einem der Ansprüche 1 bis 4, **dadurch gekennzeichnet, dass** der wenigstens eine externe Wärmetauscher (22; 44) ebenfalls in die Gehäusewand des Schutzgehäuses (20) integriert ist.

8. Instrumenten-Schutzgehäuse nach Anspruch 7, **dadurch gekennzeichnet,**
**dass** der wenigstens eine externe Wärmetauscher (22; 44) zusammen mit dem wenigstens einen internen Wärmetauscher (23; 43) in ein einziges Wärmetauscher-Wandelement (21; 41) integriert ist,
**dass** in dem Wärmetauscher-Wandelement (21; 41) Mittel (26; 42) angeordnet sind, mittels dem bzw. denen der externe Wärmetauscher (22; 44) von dem internen Wärmetauscher (23; 43) thermisch isoliert ist, und **dass** in dem Wärmetauscher-Wandelement (21; 41) ferner Mittel (34, 35; 45, 46, 47, 48) vorgesehen sind, mittels denen der externe Wärmetauscher (22; 44) und der interne Wärmetauscher (23; 43) strömungsverbunden sind.

9. Instrumenten-Schutzgehäuse nach Anspruch 8, **dadurch gekennzeichnet,**
**dass** das Wärmetauscher-Wandelement (21; 41) zweikammrig mit einer den internen Wärmetauscher (23; 43) ausbildenden ersten Hohlkammer als erstes Aufnahmevolumen und mit einer den externen Wärmetauscher (22; 44) ausbildenden zweiten Hohlkammer als zweites Aufnahmevolumen aufgebaut ist, und
**dass** die beiden Hohlkammern und damit die beiden Wärmetauscher (22, 23; 43, 44) durch eine im Wärmetauscher-Wandelement (21; 41) verlaufende, vorzugsweise parallel zu einer Innenwand (24) und einer Außenwand (25) verlaufende, die beiden Hohlkammern voneinander thermisch isolierende Zwischenschicht, vorzugsweise Zwischenwand (26; 42) als Trennebene getrennt sind.

10. Instrumenten-Schutzgehäuse nach Anspruch 9, **dadurch gekennzeichnet,**
**dass** der den internen Wärmetauscher (23; 43) zum Innenraum (27) des Schutzgehäuses (20) hin begrenzende Wandbereich durch die Innenwand (24) des Wärmetauscher-Wandelementes (21; 41) gebildet ist, die wenigstens in diesem Bereich wenigstens bereichsweise aus einem wärmedurchlässigen Material, vorzugsweise Aluminium, gebildet ist,
**dass** der den externen Wärmetauscher (22; 44) zur Außenumgebung des Schutzgehäuses (20) hin begrenzende Wandbereich durch die Außenwand (25) des Wärmetauscher-Wandelementes (21; 41) gebildet ist, die wenigstens in diesem Bereich wenigstens bereichsweise aus einem wärmedurchlässigen Material, vorzugsweise Aluminium, gebildet ist, und
**dass** das bzw. die Mittel (34, 35; 45, 46, 47, 48) zur Strömungsverbindung zwischen dem externen Wärmetauscher (22; 44) und dem internen Wärmetauscher (23; 43) in die isolierende Zwischenwand (26; 42) integriert sind.

11. Instrumenten-Schutzgehäuse nach Anspruch 10, **dadurch gekennzeichnet, dass** in die isolierende Zwischenwand (26; 42) des Wärmetauscher-Wandelementes (21; 41) wenigstens zwei Überströmverbindungen (34, 35; 45, 46, 47, 48) zwischen dem externen Wärmetauscher (22; 44) und dem internen Wärmetauscher (23; 43) integriert sind, die in Hochachsenrichtung des Schutzgehäuses (20) und des Wärmetauscher-Wandelementes (21; 41) gesehen auf unterschiedlichen Höhenniveaus liegen dergestalt, dass zwischen dem externen Wärmetauscher (22; 44) und dem internen Wärmetauscher (23; 43) in Abhängigkeit von vorgegebenen Parametern, insbesondere der Innentemperatur des Schutzgehäuses (20) und der Temperatur der Außenumgebung des Schutzgehäuses (20), wenigstens zeitweise ein natürlicher oder mit Hilfsmitteln angeregter Kreislauf ausbildbar ist, während dem eine warme Wärmetausch-Flüssigkeit, vorzugsweise warmes Wasser, über die wenigstens eine obere Überströmverbindung (35) aus einem warmen Schichtbereich des in dem internen Wärmetauscher (23; 43) aufgenommenen Teils der Wärmetausch-Flüssigkeit in den externen Wärmetauscher (22; 44) überströmt und dort in einem seiner Temperatur entsprechenden warmen Schichtbereich des dort aufgenommenen Teils der Wärmetausch-Flüssigkeit eingeschichtet wird, und während dem eine kalte Wärmetausch-Flüssigkeit, vorzugsweise kaltes Wasser, über die wenigstens eine untere Überströmverbindung (34) aus einem kalten Schichtbereich des in dem externen Wärmetauscher (22; 44) aufgenommenen Teils der Wärmetausch-Flüssigkeit in den internen Wärmetauscher (23; 43) überströmt und dort in einem seiner Temperatur entsprechenden kalten Schichtbereich des dort aufgenommenen Teils der Wärmetausch-Flüssigkeit eingeschichtet wird.

12. Instrumenten-Schutzgehäuse nach einem der Ansprüche 1 bis 11, **dadurch gekennzeichnet, dass** zur Stabilisierung des Wärmetauscher-Wandbereichs (41) in dem bzw. den dort ausgebildeten Volumina für das Wärmetauscher-Medium wenigstens eine Versteifungsrippe (51, 52) vorgesehen ist, die sich zwischen gegenüberliegenden Wandbereichen (24, 25) abstützt und eine Schichtung bzw. Strömung freigibt.

13. Instrumenten-Schutzgehäuse nach einem der Ansprüche 2 bis 12, **dadurch gekennzeichnet, dass** das Wärmetauscher-Wandelement (3; 21) durch ein Sandwichelement mit einer stabilen Innenwand (8; 24) und einer stabilen Außenwand (5; 25) sowie einer dazwischen liegenden Wärmedämmschicht (26, 31, 32; 42) als Isolierschicht, vorzugsweise einem PU-Material, gebildet ist, wobei das Aufnahmevolumen der Wärmetauscher (4; 22, 23; 43, 44) in der Wärmedämmschicht (26, 31, 32; 42) ausgebildet ist.

14. Instrumenten-Schutzgehäuse nach einem der Ansprüche 1 bis 13, **dadurch gekennzeichnet,**
**dass** der Wärmetauscher-Wandbereich (54) Bestandteil eines vorzugsweise mehrteiligen Instrumenten-Schutzkastens (53) ist und auf der dem Innenraum (55) zugewandten Innenseite eine Isolierschicht (56), vorzugsweise aus einem Schaummaterial, aufweist, in die der interne und gegebenenfalls externe Wärmetauscher (57) integriert, vorzugsweise ausgespart bzw. ausgebildet ist, und
**dass** die Isolierschicht (56) zum Innenraum (55) hin wenigstens im Bereich des internen Wärmetauschers (57) mit einer Schicht (58) aus wärmedurchlässigen Material, vorzugsweise einer Aluminiumfolie, versehen ist.
